# EUROPÄISCHE PATENTSCHRIFT

(11) **EP 0 758 690 B1**
(45) Veröffentlichungstag und Bekanntmachung des Hinweises auf die Patenterteilung: **10.11.1999**
(21) Anmeldenummer: 96112764.4
(22) Anmeldetag: 08.08.1996
(51) Int. Cl.: C30B 15/20, C30B 15/22, C30B 15/26, C30B 15/00

(54) **Verfahren und Vorrichtung zur Bestimmung des Durchmessers eines wachsenden Einkristalls**
Method and apparatus for determining the diameter of a growing single crystal
Procédé et dispositif pour la détermination pendant sa croissance du diamètre d'un monocristal

(30) Priorität: 10.08.1995 DE 19529485
(43) Veröffentlichungstag der Anmeldung: 19.02.1997
(73) Patentinhaber: Wacker Siltronic Gesellschaft für Halbleitermaterialien Aktiengesellschaft, 84489 Burghausen (DE)
(72) Erfinder: von Ammon, Wilfried, Dr., 84489 Burghausen (DE); Weidner, Herbert, 84533 Haiming (DE); Thanner, Ludwig, 84524 Neuötting (DE)
(74) Vertreter: Rimböck, Karl-Heinz, Dr.

(56) Entgegenhaltungen:
- DE-A- 2 923 240
- GB-A- 1 209 580
- JOURNAL OF THE ELECTROCHEMICAL SOCIETY, JUNE 1974, USA, Bd. 121, Nr. 6, ISSN 0013-4651, Seiten 822-826, XP002014771 PRUETT H D ET AL: "X-ray imaging technique for observing liquid encapsulation Czochralski crystal growth"
- 3RD INTERNATIONAL CONFERENCE ON CRYSTAL GROWTH, MARSEILLE, FRANCE, 5-9 JULY 1971, Bd. 13-14, ISSN 0022-0248, JOURNAL OF CRYSTAL GROWTH, MAY 1972, NETHERLANDS, Seiten 619-623, XP002014772 GARTNER K J ET AL: "An electronic device including a TV-system for controlling the crystal diameter during Czochralski growth"

## Beschreibung

Gegenstand der Erfindung ist ein Verfahren zur Bestimmung des Durchmessers eines an einer Kristallisationsgrenze wachsenden Einkristalls während des Ziehens des Einkristalls aus einer Schmelze. Gegenstand der Erfindung ist auch eine Vorrichtung zur Durchführung des Verfahrens.

Beim Ziehen von Einkristallen aus Halbleitermaterial nach der sogenannten Czochralski-Methode muß der Durchmesser des Einkristalls überwacht, das heißt bestimmt und gegebenenfalls beeinflußt werden können. Der Durchmesser des Einkristalls, der vom radialen Wachstum des Einkristalls an der Kristallisationsgrenze abhängt, kann beispielsweise beeinflußt werden, indem die Ziehgeschwindigkeit oder die Temperatur der Schmelze im Bereich der Kristallisationsgrenze gezielt geändert werden.

Eine einfache Abschätzung des Durchmessers des Einkristalls gelingt bereits durch Beobachten des Einkristalls und der Kristallisationsgrenze durch ein Schauglas in der Ziehvorrichtung. In der US-4,350,557 ist ein automatisiertes, optisches Verfahren zur Überwachung des Durchmessers eines Einkristalls beschrieben, bei dem die Bestimmung des Durchmessers auf einer Messung elektromagnetischer Strahlung beruht, die vom Meniskus an der Kristallisationsgrenze reflektiert wird. In der US-4,794,263 ist eine Vorrichtung gezeigt, die geeignet ist, den Durchmesser des wachsenden Einkristalls durch Messung der Leuchtstärke des Meniskus und der Höhe der Schmelze zu bestimmen. Der US-5,223,078 ist ein Verfahren zu entnehmen, das dazu dient, das Ziehen des konischen Abschnittes an der Spitze des Einkristalls (Anfangskonus) zu überwachen und die Länge dieses Abschnitts zu verkürzen, da er für die Herstellung elektronischer Bauelemente ungeeignet ist.

Mit den genannten Verfahren ist es allerdings nicht möglich, den Durchmesser des Einkristalls zu bestimmen, während der konische Abschnitt am Ende des Einkristalls (Endkonus) gezogen wird. Während dieser Phase des Kristallzugs verdeckt der zylindrische Abschnitt des Einkristalls, der üblicherweise nach dem Anfangskonus gezogen wird, den Blick zur Kristallisationsgrenze. Der Endkonus muß daher nahezu "blind", das heißt, ohne eine verläßliche Möglichkeit der Bestimmung des Durchmessers des Einkristalls gezogen werden. Dadurch kommt es häufig zu unbeabsichtigten Schwankungen des radialen Wachstums, die die Versetzungsbildung erhöhen. Besonders ungünstig ist ein Abreißen des Kontaktes zwischen Schmelze und wachsendem Einkristall. In diesem Fall kommt es nicht nur zur Bildung von Versetzungen, sondern es können durch die Erzeugung von Oberflächenwellen auf der Schmelzenoberfläche und durch Schmelzspritzen auch Beschädigungen von Graphitteilen der Ziehanlage auftreten. Die erzeugten Versetzungen breiten sich vom Ort ihrer Entstehung etwa eine Kristalldurchmesser-Länge zurück in den bereits gezogenen Einkristall aus. Da versetztes Halbleitermaterial für elektronische Zwecke unbrauchbar ist, ist der Schaden besonders groß, wenn Einkristalle mit Durchmessern von mehr als 150 mm, von der Entstehung von Versetzungen beim Ziehen des Endkonus betroffen sind. Die Versetzungen reichen dann besonders weit in den zylindrischen Abschnitt des Einkristalls hinein, der normalerweise zur Herstellung elektronischer Bauelemente verwendet wird und bei Einkristallen dieser Größenordnung verfahrensbedingt ohnehin wesentlich kürzer ist, als bei Einkristallen mit kleineren Durchmessern.

In einer Veröffentlichung von H. D. Pruett und S. Y. Lien ist offenbart, daß eine Röntgenquelle bereitgestellt werden kann, mit deren Hilfe ein wachsender Einkristall in Echtzeit auf einem TV-Monitor abgebildet werden kann (H. D. Pruett and S. Y. Lien, J. Electrochem. Society, Bd. 121, Nr. 6, ISSN 0013-4651, Seiten 822-826, June 1974).

Die Aufgabe der Erfindung besteht darin, ein Verfahren anzugeben, bei dem Schwankungen des radialen Wachstums des Einkristalls und das Entstehen von Versetzungen, insbesondere beim Ziehen des Endkonus, vermieden werden können.

Gegenstand der Erfindung ist ein Verfahren zur Bestimmung des Durchmessers eines an einer Kristallisationsgrenze wachsenden Einkristalls während des Ziehens des Einkristalls aus einer Schmelze, wobei ein Teil der Kristallisationsgrenze auf mindestens einem Spiegel abgebildet und das Spiegelbild beobachtet wird, und der Durchmesser des Einkristalls anhand der beobachteten relativen Lage der Kristallisationsgrenze auf dem Spiegelbild bestimmt wird, dadurch gekennzeichnet, daß in der Endphase des Ziehens des Einkristalls, wenn der Durchmesser des Einkristalls zu einem Endkonus verringert wird, ein über der Schmelze angeordneter Spiegel beobachtet wird und die im Spiegelbild enthaltene Information über den Durchmesser des Einkristalls verwendet wird, um den Durchmesser des Einkristalls gegebenenfalls zu ändern.

Das Verfahren gestattet die ständige Überwachung des Durchmessers eines Einkristalls im Bereich der Kristallisationsgrenze. Es ermöglicht insbesondere, daß auch der Endkonus kontrolliert gezogen werden kann, indem ungewollte Änderungen des Durchmessers sofort erkannt und korrigiert werden können. Mit dem Verfahren kann das Ziehen des Endkonus besonders vorteilhaft automatisiert werden. Außerdem gestattet das Verfahren, den Endkonus kürzer zu ziehen, als es bisher üblich ist.

Die Information über den Durchmesser, den der wachsende Einkristall an seiner Kristallisationsgrenze gerade aufweist,wird aus der Beobachtung eines Spiegelbilds gewonnen, das ein Spiegel zeigt, der zumindest einen Teil der Kristallisationsgrenze abbildet. Die Kristallisationsgrenze ist im Spiegelbild an dem scharf abgegrenzten Helligkeitswechsel zwischen dem oben abgebildeten Einkristall und der darunter abgebildeten Schmelze deutlich erkennbar. Solange sich der Durchmesser des Einkristalls während des Kristallzugs nicht ändert oder geändert wird, bleibt die Lage der Kristallisationsgrenze auf dem Spiegelbild ebenfalls unverändert. Beim Anwachsen des Durchmessers des Einkristalls nimmt der abgebildete Teil des Einkristalls zu, so daß ein Beobachter die Kristallisationsgrenze im Spiegelbild nach unten wandern sieht. Bei abnehmendem Kristalldurchmesser sind die Verhältnisse gerade umgekehrt, so daß die abgebildete Kristallisationsgrenze aus der Sicht des Beobachters während des Ziehens des Endkonus auf dem Spiegelbild nach oben wandert. Der relativen Lage des abgebildeten Teils der Kristallisationsgrenze auf dem Spiegelbild kann daher ein bestimmter Kristalldurchmesser zugeordnet werden. Die Zuordnung erfolgt beispielsweise durch Eichen an Meßergebnissen von Durchmesser-Bestimmungen, die beim Ziehen des Anfangskonus gleichzeitig mit der Beobachtung des Spiegels durchgeführt werden, wobei die Messungen auf bekannten Methoden beruhen und zum Teil in den oben genannten Patenten beschrieben sind.

Natürlich ist auch eine Abschätzung des Durchmessers ohne vorherige Eichung möglich. Ein im Ziehen von Einkristallen erfahrener Techniker wird durch das Schauglas der Ziehanlage die Kristallisationsgrenze zunächst direkt und im Spiegel beobachten. Beim Ziehen des Endkonus, wenn die direkte Beobachtung der Kristallisationsgrenze nicht mehr möglich ist, reicht dann die alleinige Beobachtung des Spiegels aus, um zu entscheiden, ob und in welche Richtung der Durchmesser geändert werden muß.

Gemäß einer bevorzugten Ausführungsform des Verfahrens wird eine Serie von Spiegelbildern während des Ziehens des Einkristalls von einer elektronischen Kamera aufgezeichnet. Jedes Spiegelbild wird rechnergestützt zu einem Datensatz verarbeitet, der die Information über den vom Spiegelbild repräsentierten Kristalldurchmesser enthält. Dies geschieht dadurch, daß bei der elektronischen Bildverarbeitung die relative Lage der Kristallisationsgrenze auf dem Spiegelbild als Unterscheidungsmerkmal erfaßt und einem bestimmten Durchmesser zugeordnet wird. Der einem Spiegelbild zugeordnete Durchmesser ist ein Eichwert, den man durch eine an sich bekannte Durchmesser-Bestimmung, die gleichzeitig mit der Beobachtung des Spiegelbilds während des Ziehens des Anfangskonus erfolgte, erhalten hat. Die Spiegelbilder, die beim Ziehen des Anfangskonus des Einkristalls beobachtet werden können, sind beim Ziehen von dessen Endkonus in umgekehrter Reihenfolge wieder zu beobachten. Es ist daher ausreichend, Datensätze vom Ziehen des Anfangskonus und des zylindrischen Teils des Einkristalls zu erstellen. Während des Ziehens des Endkonus des Einkristalls, wenn die bekannten Methoden der Durchmesser-Bestimmung versagen, wird dann nur noch die Lage der Kristallisationsgrenze auf dem Spiegelbild ermittelt und über die vorher erstellten Datensätze der entsprechende Kristalldurchmesser zugeordnet. Prinzipiell könnte die Zuordnung eines bestimmten Durchmessers zu einem beobachteten Spiegelbild auch dadurch erfolgen, daß der entsprechende Durchmesser über geometrische Rechnungen ermittelt wird.

Mit einer genügend großen Anzahl von Datensätzen läßt sich der Durchmesser des Einkristalls zu jedem Zeitpunkt des Kristallzugs bestimmen. Im Prinzip ist es möglich, in einer Ziehanlage mehrere Einkristalle nacheinander zu ziehen und zur Bestimmung des Durchmessers eines Einkristalls die beim Ziehen des ersten Einkristalls erstellten Datensätze zu verwenden. Da der Spiegel nach jedem Kristallzug gereinigt oder gegebenenfalls ausgewechselt werden muß, ist es bevorzugt, beim Ziehen des Anfangskonus eines neuen Einkristalls auch neue Datensätze zu erstellen und diese insbesondere dann zur Bestimmung des Durchmessers des Einkristalls zu verwenden, wenn der Endkonus des Einkristalls gezogen wird.

Die Bestimmung des Durchmessers eines Einkristalls an Hand eines beobachteten Spiegelbilds wird verwendet, um den Durchmesser des Einkristalls in Übereinstimmung mit einem vorgegebenen Solldurchmesser zu halten. Ergibt eine Bestimmung des Durchmessers eine Abweichung vom Solldurchmesser, werden die Ziehbedingungen, beispielsweise die Ziehgeschwindigkeit oder die Temperatur der Schmelze im Bereich der Kristallisationsgrenze, so verändert, daß sich der Durchmesser des Einkristalls dem Solldurchmesser wieder anpaßt.

Gegenstand der Erfindung ist auch eine Vorrichtung zur Bestimmung des Durchmessers eines an einer Kristallisationsgrenze wachsenden Einkristalls während des Ziehens des Einkristalls aus einer Schmelze, mit mindestens einem beobachtbaren Spiegel, der seitlich des wachsenden Einkristalls angeordnet und so geneigt ist, daß sich auf seiner Oberfläche ein Teil der Kristallisationsgrenze abbildet, dadurch gekennzeichnet, daß der Spiegel über der Schmelze angeordnet ist, und auch in der Endphase des Ziehens des Einkristalls, wenn der Durchmesser des Einkristalls zu einem Endkonus verringert wird, ein Teil der Kristallisationsgrenze auf dem Spiegel abgebildet wird.

Die Erfindung wird nachfolgend mit Hilfe von drei Figuren näher erläutert. In den Figuren sind nur Merkmale dargestellt, die zum Verständnis der Erfindung beitragen.

Figur 1 zeigt schematisch eine Ziehanlage zum Ziehen eines Einkristalls aus einer Schmelze.
Die Figuren 2a und 2b sind schematische Darstellungen vom Blick in die Ziehanlage zu verschiedenen Zeitpunkten eines Kristallzugs.

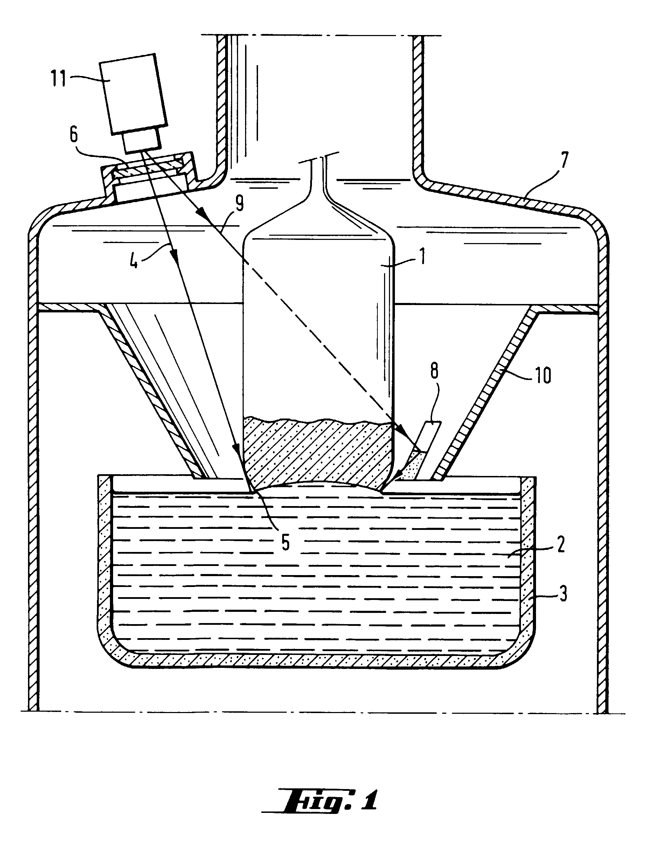

In Figur 1 ist die Situation beim Ziehen des Endkonus des Einkristalls 1 dargestellt. Der Einkristall wird mit Hilfe einer bekannten und deshalb nicht gezeigten Zieheinrichtung aus einer Schmelze gezogen. Die Schmelze wird von einem Tiegel 3 gehalten. Der Blick 4 zur Kristallisationsgrenze 5 durch das Schauglas 6 im Rezipienten 7 ist während dieser Phase des Kristallzugs nicht möglich, weil ein Teil des bereits gezogenen zylindrischen Abschnitts des Einkristalls die Kristallisationsgrenze verdeckt. Es ist daher ein Spiegel 8 vorgesehen, der seitlich vom Einkristall 1 und über der Schmelze 2 angeordnet und bezüglich der Wachstumsrichtung des Einkristalls so geneigt ist, daß ein Teil der Kristallisationsgrenze 5 darauf abgebildet wird und aus einer Blickrichtung 9 durch das Schauglas 6, beispielsweise mit Hilfe einer Kamera 11, beobachtet werden kann. Gegebenenfalls können auch mehrere Spiegel bereitgestellt werden, die beispielsweise unterschiedlich stark geneigt sind oder unterschiedlich weit zur Oberfläche der Schmelze beabstandet sind.

Bekanntermaßen entweicht beim Ziehen von Silicium-Einkristallen nach der Czochralski-Methode gasförmiges Siliciummonoxid aus der Schmelze, das sich an kälteren Anlageteilen als Feststoff niederschlagen kann. Es ist daher notwendig, daß der Spiegel 8 von Inertgas umspült und dadurch frei von Ablagerungen gehalten wird. Da der Rezipient üblicherweise ohnehin mit Inertgas gespült wird und ein Inertgasstrom zwischen den wachsenden Einkristall und einem Hitzeschild zur Schmelze geführt wird, wird der Spiegel 8 vorzugsweise an einem oberhalb der Schmelze 2 angeordneten, konus- oder rohrförmigen Hitzeschild 10 befestigt. Es ist natürlich auch möglich, den Spiegel an der Spitze einer eigens dafür vorgesehenen Lanze zu befestigen, die in den Raum oberhalb der Schmelze gehalten wird, und ihn gegebenenfalls über eine besondere Einrichtung mit Inertgas zu spülen. In der deutschen Patentanmeldung mit der Anmeldenummer P 195 03 357 ist ein kühlbarer Hitzeschild aus Silber offenbart. Wenn die Innenwand eines solchen Hitzeschilds an einer geeigneten Stelle hochglanzpoliert wird, kann sie als Spiegel im Sinne der Erfindung eingesetzt werden. Darüber hinaus ist ein Spiegel aus hochglanzpoliertem Silicium besonders bevorzugt, vor allem, wenn Einkristalle aus Silicium gezogen werden. Vorzugsweise wird der Spiegel aus einer polierten Siliciumscheibe, dem Grundmaterial für die Herstellung elektronischer Bauelemente, gefertigt.

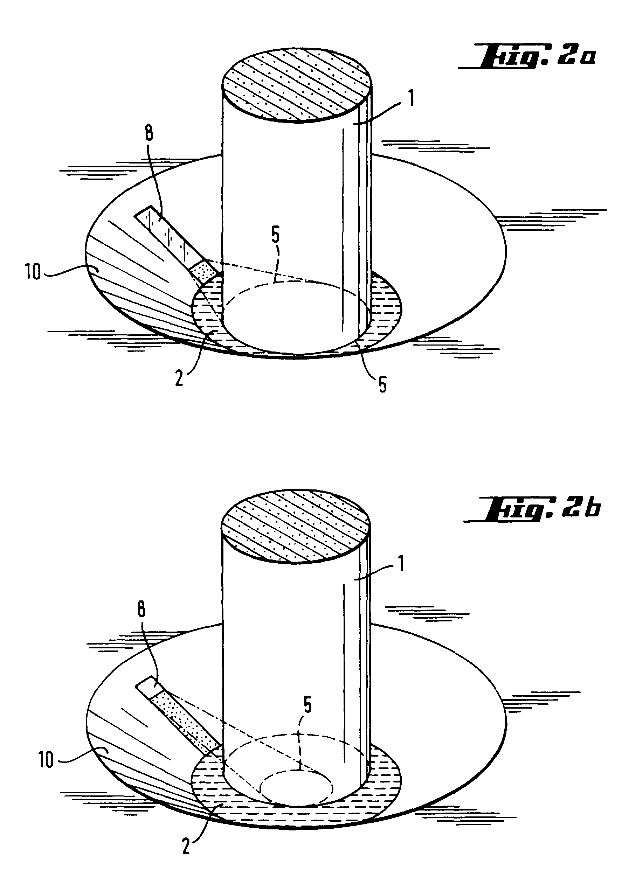

In Figur 2a ist das Blickfeld der Kamera 11 (Figur 1) zu einem Zeitpunkt dargestellt, zu dem der zylindrische Teil des Einkristalls 1 gezogen wird. Auf dem Spiegel 8, der am Hitzeschild 10 befestigt ist, ist der abgebildete Teil der Kristallisationsgrenze an einem scharf abgegrenzten Helligkeitswechsel erkennbar. Dieser Helligkeitswechsel wird zu einem späteren Zeitpunkt, zu dem der Endkonus des Einkristalls gezogen wird (Figur 2b) und der Durchmesser des Einkristalls 1 geringer geworden ist, auf dem Spiegel an einer höheren Position beobachtet.

## Patentansprüche

1. Verfahren zur Bestimmung des Durchmessers eines an einer Kristallisationsgrenze wachsenden Einkristalls während des Ziehens des Einkristalls aus einer Schmelze, wobei ein Teil der Kristallisationsgrenze auf mindestens einem Spiegel abgebildet und das Spiegelbild beobachtet wird, und der Durchmesser des Einkristalls anhand der beobachteten relativen Lage der Kristallisationsgrenze auf dem Spiegelbild bestimmt wird, dadurch gekennzeichnet, daß in der Endphase des Ziehens des Einkristalls, wenn der Durchmesser des Einkristalls zu einem Endkonus verringert wird, ein über der Schmelze angeordneter Spiegel beobachtet wird und die im Spiegelbild enthaltene Information über den Durchmesser des Einkristalls verwendet wird, um den Durchmesser des Einkristalls gegebenenfalls zu ändern.

2. Verfahren nach Anspruch 1, dadurch gekennzeichnet, daß eine bestimmte relative Lage der Kristallisationsgrenze auf dem Spiegelbild einem Durchmesser des Einkristalls zugeordnet ist, der sich aus der Bestimmung des Durchmessers auf bekannte Weise ergibt.

3. Verfahren nach Anspruch 1 oder Anspruch 2, dadurch gekennzeichnet, daß während des Ziehens des Einkristalls Spiegelbilder von einer elektronischen Kamera aufgenommen werden und rechnerunterstützt zu Datensätzen verarbeitet werden, die eine Information über den Durchmesser des wachsenden Einkristalls enthalten, und diese Information verwendet wird, um den Durchmesser des Einkristalls gegebenenfalls zu ändern.

4. Vorrichtung zur Bestimmung des Durchmessers eines an einer Kristallisationsgrenze wachsenden Einkristalls während des Ziehens des Einkristalls aus einer Schmelze, mit mindestens einem beobachtbaren Spiegel, der seitlich des wachsenden Einkristalls angeordnet und so geneigt ist, daß sich auf seiner Oberfläche ein Teil der Kristallisationsgrenze abbildet, dadurch gekennzeichnet, daß der Spiegel über der Schmelze angeordnet ist, und auch in der Endphase des Ziehens des Einkristalls, wenn der Durchmesser des Einkristalls zu einem Endkonus verringert wird, ein Teil der Kristallisationsgrenze auf dem Spiegel abgebildet wird.

5. Vorrichtung nach Anspruch 4, dadurch gekennzeichnet, daß der Spiegel aus poliertem Silicium besteht und an einem Hitzeschild befestigt ist, der oberhalb der Schmelze angeordnet ist.

6. Vorrichtung nach Anspruch 4, dadurch gekennzeichnet, daß der Spiegel aus poliertem Silicium besteht und am Ende einer Lanze befestigt ist, die in den Raum oberhalb der Schmelze ragt.

7. Vorrichtung nach Anspruch 4, dadurch gekennzeichnet, daß der Spiegel aus poliertem Silber besteht und Teil eines gekühlten Hitzeschildes ist, der oberhalb der Schmelze angeordnet ist.

8. Vorrichtung nach einem der Ansprüche 4 bis 8, gekennzeichnet durch eine Einrichtung zum Umspülen des Spiegels mit Inertgas.

## Claims

1. Method for determining the diameter of a monocrystal growing at a crystallization boundary during the pulling of the monocrystal from a melt, where a part of the crystallization boundary is imaged on at least one mirror, the mirror image is observed and the diameter of the monocrystal is determined from the observed relative position of the crystallization boundary on the mirror image, characterized in that, in the final phase of the pulling of the monocrystal, when the diameter of the monocrystal is reduced to form a terminal cone, a mirror which is disposed above the melt is observed and the information contained in the mirror image about the diameter of the monocrystal is used to change the diameter of the monocrystal if necessary.

2. Method according to Claim 1, characterized in that a certain relative position of the crystallization boundary on the mirror image is correlated with a diameter of the monocrystal which emerges from the determination of the diameter in a known manner.

3. Method according to Claim 1 or Claim 2, characterized in that mirror images are recorded by an electronic camera during the pulling of the monocrystal and are processed by means of a computer to form data sets which contain information about the diameter of the growing monocrystal, and this information is used to change the diameter of the monocrystal if necessary.

4. Device for determining the diameter of a monocrystal growing at a crystallization boundary during the pulling of the monocrystal from a melt, having at least one observable mirror which is disposed at the side of the growing monocrystal and is inclined so that a part of the crystallization boundary is imaged on its surface, characterized in that the mirror is disposed above the melt, and, also in the final phase of the pulling of the monocrystal, when the diameter of the monocrystal is reduced to form a terminal cone, a part of the crystallization boundary is imaged on the mirror.

5. Device according to Claim 4, characterized in that the mirror is composed of polished silicon and is mounted on a heat shield disposed above the melt.

6. Device according to Claim 4, characterized in that the mirror is composed of polished silicon and is mounted on the end of a lance which projects into the space above the melt.

7. Device according to Claim 4, characterized in that the mirror is composed of polished silver and is part of a cooled heat shield disposed above the melt.

8. Device according to any of Claims 4 to 8, characterized by a device for flushing the mirror with inert gas.

## Revendications

1. Procédé pour déterminer le diamètre d'un monocristal en croissance à une limite de cristallisation au cours du tirage du monocristal d'une masse fondue, dans lequel une partie de la limite de cristallisation forme une image sur au moins un miroir et l'image du miroir est observée, et le diamètre du monocristal est déterminé à partir de la position relative observée de la limite de cristallisation sur l'image du miroir, caractérisé en ce que, dans la phase finale du tirage du monocristal, lorsque le diamètre du monocristal est réduit pour former un cône terminal, on observe un miroir agencé au-dessus de la masse fondue et on utilise les informations contenues dans l'image du miroir sur le diamètre du monocristal pour modifier éventuellement le diamètre du monocristal.

2. Procédé selon la revendication 1, caractérisé en ce qu'on affecte une certaine position relative de la limite de cristallisation sur l'image du miroir à un diamètre du monocristal que l'on obtient par détermination du diamètre de manière connue.

3. Procédé selon la revendication 1 ou 2, caractérisé en ce que des images du miroir sont enregistrées par une caméra électronique au cours du tirage du monocristal et sont traitées par un ordinateur pour obtenir des jeux de données qui contiennent des informations sur le diamètre du monocristal en cours de croissance et on utilise ces informations pour modifier éventuellement le diamètre du monocristal.

4. Dispositif pour déterminer le diamètre d'un monocristal en cours de croissance à une limite de cristallisation pendant le tirage du monocristal d'une masse fondue, ayant au moins un miroir observable qui est disposé latéralement par rapport au monocristal en cours de croissance et est incliné de telle sorte qu'une partie de la limite de cristallisation forme une image à sa surface, caractérisé en ce que le miroir est agencé au-dessus de la masse fondue et une partie de la limite de cristallisation forme également une image sur le miroir dans la phase finale du tirage du monocristal, lorsque le diamètre du monocristal est réduit pour former un cône terminal.

5. Dispositif selon la revendication 4, caractérisé en ce que le miroir est constitué de silicium poli et est fixé à un écran thermique qui est agencé au-dessus de la masse fondue.

6. Dispositif selon la revendication 4, caractérisé en ce que le miroir est constitué de silicium poli et est fixé à l'extrémité d'une lance qui fait saillie dans l'espace situé au-dessus de la masse fondue.

7. Dispositif selon la revendication 4, caractérisé en ce que le miroir est constitué d'argent poli et fait partie d'un écran thermique refroidi qui est agencé au-dessus de la masse fondue.

8. Dispositif selon l'une quelconque des revendications 4 à 8, caractérisé par un dispositif pour nettoyer le miroir par un gaz inerte.
